(19) Europäisches Patentamt
European Patent Office
Office européen des brevets

(11) **EP 4 531 166 A1**

(12) **EUROPEAN PATENT APPLICATION**

(43) Date of publication:
02.04.2025 Bulletin 2025/14

(21) Application number: 23200167.7

(22) Date of filing: 27.09.2023

(51) International Patent Classification (IPC):
H01M 10/48 (2006.01)    G01R 31/389 (2019.01)
G01R 31/396 (2019.01)    H01M 50/51 (2021.01)
H01M 50/569 (2021.01)    H01M 50/548 (2021.01)

(52) Cooperative Patent Classification (CPC):
H01M 10/482; G01R 31/389; G01R 31/396;
H01M 50/51; H01M 50/548; H01M 50/569

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: NXP USA, Inc.
Austin TX 78735 (US)

(72) Inventor: van Lammeren, Joop Petrus Maria
5656 AG Eindhoven (NL)

(74) Representative: Schmütz, Christian Klaus
Johannes
NXP Semiconductors Germany GmbH
Intellectual Property Group
Beiersdorfstr. 12
22529 Hamburg (DE)

(54) **BATTERY SYSTEM**

(57) The present invention relates to a battery system comprising: a first battery cell, a second battery cell, a measurement unit, a first interconnection line, a first sensing line, a second sensing line, and a third sensing line, wherein the first battery cell extends in a longitudinal direction from a first battery terminal to a second battery terminal, wherein the second battery cell extends in the longitudinal direction from a third battery terminal to a fourth battery terminal, wherein the second battery terminal is coupled to the fourth battery terminal via the first interconnection line, the first sensing line being coupled between the first battery terminal and the measurement unit, the second sensing line being coupled between the third battery terminal and the measurement unit, wherein the third sensing line is coupled between the first interconnection line and the measurement unit, wherein the first to third sensing lines comprise at least one section referred to as the central section, and wherein each central section is arranged centrally between the first and second battery cells and extends in the longitudinal direction.

Fig. 4

## Description

TECHNICAL FIELD

The present disclosure relates to a battery system.

BACKGROUND

For automotive electronics, accurate measurement of battery cell state is often very important. One effective way to obtain the state of battery cell is to measure the impedance of battery cell. However, it is sometimes difficult to accurately measure the impedance of each battery cell of the automotive battery, since the automotive battery often tends to be relatively long and/or a large battery. For charging or discharging a battery cell, the respective battery cell can be coupled via driving lines. If a current flows through the powerlines, a magnetic field generated by the current will likely cause interference to measurement lines, which are also connected to the respective battery cell for impedance measurement. As a result, crosstalk among the driving lines and the measurement lines may occur. The impedance of a battery cell can be low, often less than 1 mΩ. A measurement signal in the measurement lines can therefore be on $\mu$V level, which can be in the same order of magnitude as the crosstalk voltage induced by the magnetic field.

SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Aspects of the disclosure are defined in the accompanying claims.

In accordance with a first aspect of the present disclosure, a battery system is provided. The battery system comprises a first battery cell, a second battery cell, a measurement unit, a first interconnection line, a first sensing line, a second sensing line, and a third sensing line, wherein the first battery cell extends in a longitudinal direction from a first battery terminal to a second battery terminal, wherein the second battery cell extends in the longitudinal direction from a third battery terminal to a fourth battery terminal, wherein the second battery terminal is coupled to the fourth battery terminal via the first interconnection line, the first sensing line being coupled between the first battery terminal and the measurement unit, the second sensing line being coupled between the third battery terminal and the measurement unit, wherein the third sensing line is coupled between the first interconnection line and the measurement unit, wherein the first to third sensing lines comprise at least one section referred to as the central section, and wherein each central section is arranged centrally between the first and second battery cells and extends in the longitudinal direction.

In one or more embodiments, the third sensing line forms one central section referred to as the third central section, and wherein the first and second sensing lines each comprise no central section.

In one or more embodiments, each of the first and second sensing lines is arranged outside a space referred to as a first intermediate space between the first and second battery cells.

In one or more embodiments, the first sensing line forms one central section referred to as the first central section, wherein the second sensing line forms another central section referred to as the second central section, wherein the third sensing line forms another central section referred to as the third central section.

In one or more embodiments, the first central section is coupled to the first battery terminal via a section of the first sensing line referred to as the first terminal section, and wherein the second central section is coupled to the third battery terminal via a section of the second sensing line referred to as the second terminal section.

In one or more embodiments, the first and second terminal sections each extend in a direction referred to as the transverse direction, which is transverse to the longitudinal direction.

In one or more embodiments, the first central section is coupled to the measurement unit via another section of the first measuring line referred to as the first connecting section, wherein the second central section is coupled to the measurement unit via another section of the second measuring line referred to as the second connecting section, and wherein the third central section is coupled to the measurement unit via another section of the third measuring line referred to as the third connecting section.

In one or more embodiments, the first to third connecting sections are arranged mostly outside a space referred to as a first intermediate space between the first and second battery cells.

In one or more embodiments, the first to third connecting sections are arranged in parallel.

In one or more embodiments, each of the first to third connecting sections extend in the transverse direction.

In one or more embodiments, the first to third connecting sections are arranged laterally offset from the battery cells.

In one or more embodiments, the third central section extends from the first interconnection line.

In one or more embodiments, the measurement unit is configured to detect an electrical impedance of the first and second battery cells.

In one or more embodiments, the first battery cell, the second battery cell, the first interconnection line,

the first sensing line, the second sensing line, and the third sensing line form a battery block of the battery system, and wherein the battery system comprises a plurality of battery blocks.

In one or more embodiments, the battery blocks are arranged parallel to each other.

In one or more embodiments, the battery system comprises at least two, three or four battery blocks.

In one or more embodiments, every second battery block has the arrangement of the first and second battery cells interchanged.

In one or more embodiments, each two battery bocks arranged side by side are connected to each other via a second interconnection line such that the second interconnection line extends from the third terminal one of the two battery bocks to the first terminal the other of the two battery bocks.

In one or more embodiments, the battery cells are arranged in parallel with each other.

In one or more embodiments, each battery cell extends in longitudinally direction over a length of at least 50 cm, at least 70cm or at least 100 cm.

DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:

Figures 1 and 2 show simplified block diagrams of a battery system.

Figure 3 shows a simplified model of a battery system.

Figure 4 shows a simplified block diagram of a battery system.

Figure 5 shows a simplified model of a battery system.

Figure 6 to 8 show simplified block diagrams of a battery system.

DESCRIPTION OF EMBODIMENTS

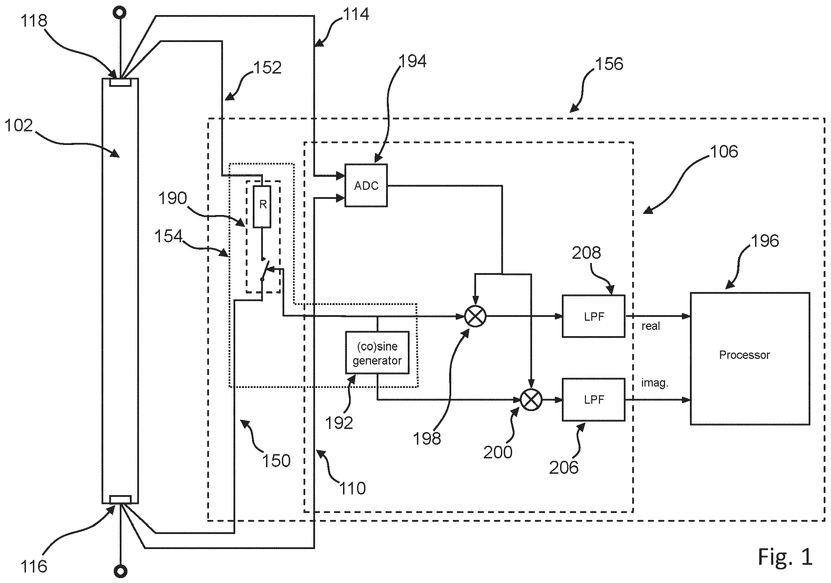

Figure 1 schematically shows is a simplified block diagram of an example of a cell control unit 156. Figure 1 also schematically shows is a simplified block diagram of an example of an impedance measurement unit 106, also referred to as measurement unit 106. The measurement unit 106 may be a part of the cell control unit 156. The cell control unit 156 may comprise a driving unit 154.

The driving unit 154 may include a digital analog converter, DAC, 190. The DAC 190 may be connected to the battery cell 102 via the driving lines 150, 152, wherein for example a first driving line 150 is extending from the DAC 190 to a first battery terminal 116 of the battery cell 102 and a second driving line 152 is extending from the DAC 190 to a second battery terminal 118 of the battery cell 102. The DAC 190 may be configured to inject a current (e.g., a sinusoidal current, square wave current, etc.) into the battery cell 102 via the driving lines 150, 152 in response to a sinusoidal input control signal. The control signal may be generated by the sine/cosine generator 192. The sine/cosine generator 192 may be part of and/or shared with the measurement unit 106.

The measurement unit 106 may be connected to a battery cell 102 via the first sensing line 110 and the second sensing line 112 to measure the impedance of the battery cell 102. In addition, the measurement unit 106 may include an analog digital converter, ADC, 194. The ADC 194 may be connected to the sensing lines 110, 114 to measure the voltage of the battery cell 102 that is generated in response to the injected current in particular by converting the resulting analog voltage ripple developed across the battery cell 102 (in particular between the first battery terminal 116 and the second battery terminal 118) to a digital value for processing by a processor 196. The outputs from the sine/cosine generator 192 and the digital output from the ADC 194 may be provided to respective mixer 198, 200 of the measurement unit 106. As a result, the digitized cell voltage may be multiplied through the mixer 198, 200 by both the sine and the cosine outputs of the signal generator 192. The outputs of the mixers 198, 200 may be passed through low-pass filters 206, 208. The outputs of the low-pass filters 206, 208 may be provided to the processor 196. The processer 196 may be configured to compute the impedance of the battery cell 102 based on the outputs of the mixer 198, 200. The impedance of the battery cell 102 may be the ratio of the voltages of the low-pass filter outputs divided by the sine current. One output of one of the filters 208 may represent the real part, the other output of the other filter 206 may represent the imaginary part of the impedance. Further details for determining the impedance of a battery cell 102 can be found in publication US2020/0036058A1.

Impedance measurement is a way to get information on the state of a battery cell 102. Especially in automotive applications it is of advantage to know the state of the battery cell 102. Measuring the impedance of a battery cell 102 of a long and/or large automotive battery block 144 can be challenging as currents flowing through various components of the battery block 144 may create a magnetic field which can induce a voltage in the sensing lines 110, 114 that connect a battery cell 102 to the measurement unit 106. The voltage induced in the sensing lines 110, 114 may add to the cell voltage that is to be measured, and hence will give rise to a potential measurement error. The signal levels in the measurement unit 106 may tend to be measured in $\mu V$. The magnetic fields associated with the currents through the driving lines 150, 152 may potentially induce a voltage of a similar level in the sensing lines 110, 114.

The impedance of a battery cell may be very low, for example between 0.01 m$\Omega$ and 1 m$\Omega$. In an example, the inductance of a sensing line 110, 114 may be approximately 1 $\mu H$. Although the inductance of the sensing line 110, 114 may appear to be small in particular for frequencies in the Hz/kHz range, but it may have a considerable influence on the impedance measurement of the battery cell 102. For example, considering that the 1$\mu H$ inductance, it may result in an impedance of 1m$\Omega$ at a frequency of 150Hz. This means that even a small inductance may result in an impedance that is comparable to an impedance of a battery cell.

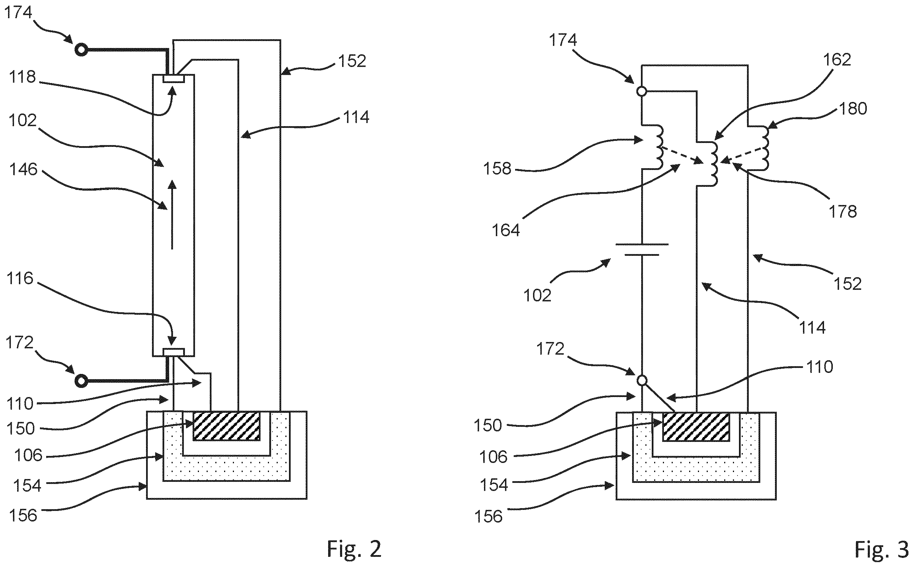

In an example, a single measurement unit 106 may be used and/or allocated to a single battery cell 102 or battery pack 144. Figure 2 schematically shows an example, where a measurement unit 106 is coupled to a single battery cell 102. A control unit 156 may comprise the measurement unit 106 and a driving unit 154. A first driving line 150 may extend from the driving unit 154 to the first battery terminal 116. A second driving line 152 may extend from the driving unit 154 to the second battery terminal 118. Furthermore, a first sensing line 110 may extend from the measurement unit 106 to the first battery terminal 116. A second sensing line 114 may extend from the measurement unit 106 to the second battery terminal 118. The driving lines 150, 152 on the one hand and the sensing lines 110, 114 on the other hand may be considered as different and/or separately configured lines. Such a setup may also be referred to as a four-wire setup and/or four-point measurement technique. The four-lines setup may have the advantage, that the resistance of the sensing lines 150, 152 may be neglected.

The driving unit 154 and the two driving lines 150, 152 may be used to drive a measurement current through the battery cell 102. The measurement unit 106 and the sensing lines 110, 114 may be used to measure the voltage of the battery cell, in particular across both battery terminals 116, 118 and in particular in response to the driving current. The measurement unit 106 and/or the control unit 156 may be configured to determine an impedance of the battery cell 102 based on the measurements, in particular the measured voltage.

The driving line 150 and the sensing line 110 connected to the cell terminal 116 may be configured to have a short length. Although both, the driving line 150 and the sensing line 110 may be neglected for a glance in the following, the effects described hereafter may apply to the driving line 150 and the sensing line 110 in an analogous manner.

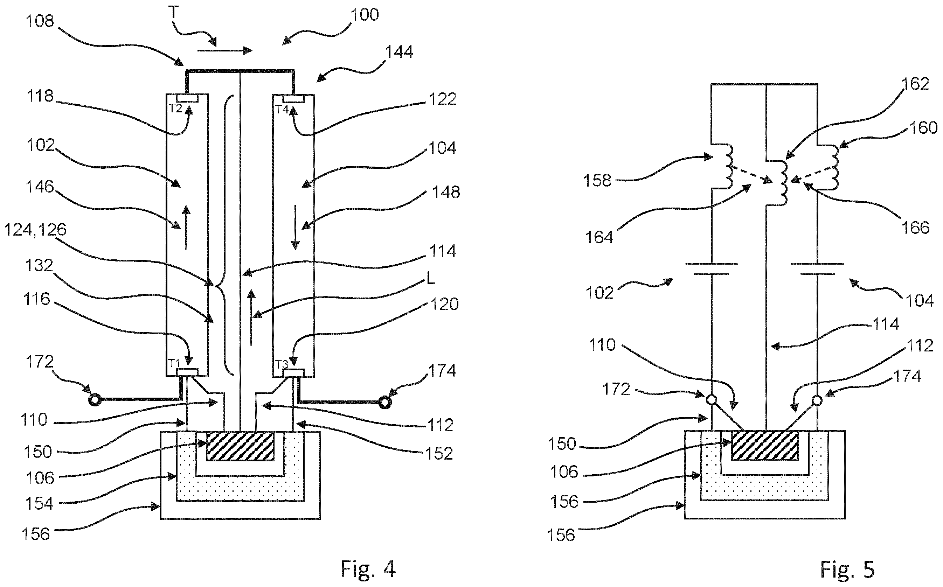

The driving current that may flow through the driving lines 150, 152 and the battery cell 102 may generate a magnetic field. This magnetic field may induce a voltage in the sensing line 114. Figure 4 schematically shows an example of a simplified electrical model of the components shown in Figure 3. Although the battery cell 102, the driving lines 150, 152, and the sensing lines 110, 114 may be considered to be magnetically coupled, in the following, attention shall be spent to a potential magnetically coupling between the battery cell 102 and the sensing line 114 as well as the potential magnetically coupling between the driving line 152 and the sensing line 114. An induced voltage in the sensing line 114 may be considered as 90 degrees out of phase with a driving current. In an example, the induced voltage may be considered to affect the imaginary part and may not affect the real part of the measurement.

In Figure 3, the inductor 158 represents an inductance Lc of battery cell 102. The inductor 162 represents an inductance $L_S$ of sensing line 114. The inductor 180 represents an inductance $L_F$ of driving line 152. The dashed arrow 164 represents a first coupling factor Kc between the battery cell 102 and the sensing line 114. The further dashed arrow 178 represents a coupling factor $K_F$ between the driving line 152 and the sensing line 114. The coupling factor $K_F$ is referred to as the fifth coupling factor $K_F$. The dashed arrows 164, 178 representing the coupling factors, in particular $K_F$, Kc, may be considered as uni directional.

The voltage induced in the sensing line 114 may be determined as:

$$v_{ind} = jwi_C K_C \sqrt{L_C L_S} + jwi_F K_F \sqrt{L_F L_S}$$

In an example, it may be assumed that a current ic, also referred to as first current 146, through the battery cell 102 is the same as a current $i_F$ flowing in opposite direction through the driving line 152. As a result, the following equation may be considered:

$$i_C = -i_F$$

As a further result, the voltage induced in the sensing line 114 may be determined as:

$$v_{ind} = jwi_C \left( K_C \sqrt{L_C L_S} - K_F \sqrt{L_F L_S} \right)$$

From the above equation, it may be derived that the crosstalk only affects the imaginary part of the impedance measurement. In practice, the crosstalk effects may be more complex and there might also be a some rather small effect on the real part. Furthermore, some rather small higher order effects may also add a small contribution to the impedance measurement.

Assuming that the rather small effects can be neglected for a moment and assuming that the battery cell 102, the driving lines 150, 152, and the sensing lines 110, 114 are in a fixed position with respect to each other, the crosstalk of the battery cell 102 and driving and sensing lines 150, 152, 110, 114 may be roughly constant. As a result, a constant measurement deviation may be assumed that can be calculated and then subtracted from the measurement results. Although this is possible in theory, in practice it can be very difficult. In particular the impedances have to be measured individually and very precisely, which is in practice almost impossible with reasonable effort. Furthermore, especially at high frequencies the induced voltage can be higher than the signal voltage on the cell. That makes the approach to subtract a constant measurement deviation from the measurement result very challenging and likely imprecise.

However, by measuring an impedance of a two series-connected cell 102, 104 with a single measurement unit 106 is much simpler while reaching a better measurement accuracy.

Figure 4 schematically illustrates an example of a battery system 100. The battery system 100 comprises a first battery cell 102, a second battery cell 104, a measurement unit 106, a first interconnect 108, a first sensing line 110, a second sensing line 112, and a third sensing line 114.

The first battery cell 102 comprises a first battery terminal 116 and a second battery terminal 118. In an example, the first battery terminal 116 and the second battery terminal 118 may be opposite poles of the first battery cell 102. The poles may be referred to as the first pole and the second pole. The first battery cell 102 extends in a longitudinal direction L from the first battery terminal 116 to the second battery terminal 118. In an example, the first battery cell 102 may be a rod-shaped battery cell 102. In an example, a diameter (in a transverse direction T) of the battery cell 102 may be significantly smaller than a length of the battery cell 102 in a longitudinal direction L. In particular, the length of the first battery cell 102 may be at least three times, four times, or five times the diameter of the first battery cells 102.

The second battery cell 104 comprises a third battery terminal 120 and a fourth battery terminal 122. In an example, the third battery terminal 120 and the fourth battery terminal 122 may be the opposite poles of the second battery cell 104. The poles may be referred to as the third pole and the fourth pole. The second battery cell 104 extends in the longitudinal direction L from the third battery terminal 120 to the fourth battery terminal 122. In an example, the second battery cell 104 may be a rod-shaped battery cell 104. In an example, a diameter (in the transverse direction T) of the battery cell 104 may be significantly smaller than a length of the battery cell 104 in the longitudinal direction L. In particular, the length of the second battery cells 104 may be at least three times, four times, or five times the diameter of the second battery cell 104. The first battery cell 102 and the second battery cell 104 may be configured at least substantially identically. In other words, the second battery cell 104 may be a duplicate of the first battery cells 102.

In an example, each battery cell 102, 104 may comprise a length in the longitudinal direction L of at least 50 cm, at least 70 cm, or at least 100 cm.

The first battery cell 102 and the second battery cell 104 may be arranged parallel to each other. In an example, the first battery cell 102 and the second battery cell 104 may extend in parallel in the longitudinal direction L. The first battery terminal 116 and the third battery terminal 120 may be aligned with each other in the transverse direction T. The second battery terminal 118 and the battery terminal 122 may be aligned with each other in the transverse direction T.

In an example, the first battery cell 102 and the second battery cell 104 are arranged relative to each other such that a first intermediate space 132 exists between the first battery cell 102 and the second battery cell 104. In an example, the first intermediate space may be a first gap. Because of the first intermediate space 132, a first distance, also referred to as a first cell spacing, may exist in the transverse direction T between the first battery cells 102 and the second battery cells 104. The cell spacing may be less than 3 mm, 2 mm, or 1 mm. In another example, the first battery cell 102 and the second battery cell 104 may be located against each other, particularly via an intermediate plate. The intermediate plate may be a cooling plate. The intermediate plate may have a thickness in transverse direction T of less than 3mm, 2mm or 1mm. In another example, the first battery cell 102 and the second battery cell 104 may be located directly against each other. The first battery cell 102 and the second battery cell 104 may each comprise a shape such that the first intermediate space 132 is between the first battery cell 102 and the second battery cell 104. The first intermediate space 132 may be above the intermediate plate. The intermediate space 132 may have a wedge cross-shaped or rectangular cross-shape.

The second battery terminal 118 of the first battery cell 102 is coupled to the fourth battery terminal 122 of the second battery cells 104 via the first interconnection line 108. The first interconnection line 108 causes the first battery cell 102 and the second battery cell 104 to be connected in series between the first battery terminal 116 and the third battery terminal 120. In an example, the first interconnection line 108 may extend directly from the second battery terminal 118 to the fourth battery terminal 122.

The first sensing line 110 is coupled between the first battery terminal 116 and the measurement unit 106. In other words, the measurement unit 106 may be electrically coupled to the first battery terminal 116 of the first battery cells 102 via the first sensing line 110. In an example, the measurement unit 106 may detect a first electrical voltage via the first sensing line 110.

The second sensing line 112 is coupled between the third battery terminal 120 and the measurement unit 106. In other words, the measurement unit 106 may be electrically coupled to the third battery terminal 120 of the second battery cells 104 via the second sensing line 112. In an example, the measurement unit 106 may detect a second electrical voltage via the second sensing line 112.

The third sensing line 114 is coupled between the first interconnection line 108 and the measurement unit 106. In other words, the measurement unit 106 may be electrically connected to the interconnection line 108 via the third sensing line 114. In an example, the measurement unit 106 may detect a third electrical voltage via the third sensing line 114. In an example, the third sensing line 114 may extend from a location on the connecting line 108 that is centrally located between the second battery terminal 118 and the fourth battery terminal 122 to the measurement unit 106.

At least one sensing line 110, 112, 114 of the three sensing lines 110, 112, 114, that is, the first sensing line 110, the second sensing line 112, and the third sensing line 114, comprises a section 124 referred to as the central section 124. In the example of the battery system 100 of Figure 4, the central section 124 is formed by the third sensing line 114. However, it is generally possible for the central section 124 to be formed by the first sensing line 110, the second sensing line 112, or the third sensing line 114. However, for the explanations in connection with the example of the battery system 100 of Figure 4, it is assumed that the central section 124 is formed by the third sensing line 114.

Each central section 124 is positioned centrally between the first battery cell 102 and the second battery cell 104. Further, each central section 124 extends in a longitudinal direction L. In an example, the central section 124 may extend in the longitudinal direction L along the entire length of and/or within the first intermediate space 132. In the transverse direction T, the central section 124 may be disposed centrally between the first battery cells 102 and the second battery cells 104. Outside of the first intermediate space 132, the third sensing line 114 may comprise other sections (not further specified here).

In an example, the system 100 may further comprise a driver unit 154. For the driver unit 154, reference is made to the advantageous explanations, preferred features, technical effects, and advantages in an analogous manner as previously explained in connection with the driver circuit 154. A first driving line 150 may extend from the driver unit 154 to the first battery terminal 116, such that the first driver unit 154 is coupled to the first battery terminal 116 via the first driving line 150. A second driving line 152 may extend from the driver unit 154 to the second battery terminal 118, such that the first driver unit 154 is coupled to the second battery terminal 118 via the second driving line 152.

In an example, the driver unit 154 may comprise a digital-to-analog converter, DAC, 190. The driving unit 154, in particular the digital-to-analog converter 190 of the driving unit 154, may be coupled to the first battery terminal 116 of the first battery cell 102 via the driving line 150 and to the third battery terminal 120 of the second battery cell 104 via the second driving line 152. The first interconnection line 108 may connect the first battery cell 102 and the second battery cell 104 in series, such that a series circuit is provided between the first battery terminal 116 and the third battery terminal 120. The driving unit 154, in particular the digital-to-analog converter 190 of the driving unit 154, may be configured to cause a current to flow through the first and second battery cells 102, 104 via the first and second driving lines 150, 152. The caused current may also be referred to as the driver current. The driver current then flows through the first and second battery cells 102, 104 at the same current level. The drive current may comprise a sinusoidal waveform, a square waveform, or another waveform, particularly another AC waveform. In an example, the digital-to-analog converter 190 of the driver unit 154 may generate the driver current based on a control signal. The control signal may be generated by the sine/cosine generator 192 of the driver unit 154. In an example, the digital-to-analog converter 190 may be coupled to the sine/cosine generator 192 via a control line such that the control signal may be transmitted from the sine/cosine generator 192 to the digital-to-analog converter 190. The sine/cosine generator 192 may form part of the measurement unit 106. However, it is also possible for the driver unit 154 to comprise its own sine/cosine generator 192.

The driving lines 150, 152 and the sensing lines 110, 112, 114 are preferably configured separately from each other. In particular, the first driving line 150 may be configured separately from the first sensing line 110. Further, the second driving line 152 may be configured separately from the second sensing line 112. In an example, the sensing lines 110, 112, 114 do not extend to the driving unit 154 but to the measurement unit 106. In an example, the driving lines 150, 152 do not extend to the measurement unit 106 but to the driving unit 154.

In an example, the sensing lines 110, 112, 114 serve to allow the measurement unit 106 to sense a first voltage at the measurement unit 106 between the first sensing line 110 and the third sensing line. Furthermore, in an example, the sensing lines 110, 112, 114 serve to allow the measurement unit 106 to sense a second voltage at the measurement unit 106 between the third sensing line 114 and the second sensing line 112. In an example, the measurement unit 106 may be configured to determine a first electrical impedance of the first battery cell 102 based on the first voltage. In an example, the measurement unit 106 may be configured to determine a second electrical impedance of the second battery cells 104 based on the second voltage. However, it is also possible that the measurement unit 106 is configured to determine a battery impedance based on the first voltage and/or the second voltage. Preferably, the first battery cell 192 and the second battery cell 104 are configured identically.

In an example, the current generated by the driving unit 154, also referred to as the driving current, may flow through the series connection of the first driving line 150, the first battery cells 102, the first connecting line 108, the second battery cells 104, and the second driving line 152. The drive current flowing through the first battery cell 102 may cause a first magnetic field. The drive current flowing through the second battery cell 104 may cause a second magnetic field. The first and second magnetic fields may each induce a voltage in the third sensing line 114, particularly in the central portion 124 of the third sensing line 114.

Referring to Figure 5, a simplified electrical model of the components of the battery system 100 is schematically shown. Although the first battery cell 102, the second battery cell 104 and the driving lines 150, 152 as well as the sensing lines 110, 112, 114 may be considered magnetically coupled in principle, attention will be directed below to the potentially relevant magnetic coupling between the first battery cells 102 and the third sensing line 114 as well as the further potentially relevant magnetic coupling between the second battery cells 104 and the third sensing line 114.

In Figure 5, the first inductor 158 represents a first inductance L1 of the first battery cell 102. The second inductor 160 represents a second inductance L2 of the second battery cells 104. The first inductance L1 and the second inductance L2 may be identical. This assumption may be justified if, for example, the first battery cell 102 and the second battery cell 104 are identical. The inductor 162 represents an inductance L3 of the third sensing line 114, in particular an inductance of the central portion 124 of the third sensing line 114. The dashed arrow 164 represents a first coupling factor K1 between the battery cell 102 and the third sensing line 114. The further dashed arrow 166 represents a second coupling factor K2 between the second battery cell 104 and the third sensing line 114. Against this background, the voltage induced in the third sensing line 114 may be calculated as follows:

$$v_{ind} = jwi_1K_1\sqrt{L_1L_3} + jwi_2K_2\sqrt{L_2L_3}$$

The drive current, which is also referred to as current i1, may flow through the first battery cell 102 in the longitudinal direction L. Further, the drive current, also referred to as current i2, may flow through the second battery cell 104 in a direction opposite to the longitudinal direction L. As a result, the following equation holds:

$$i_1 = -i_2$$

In an example, it may further be considered that the two coupling factors K1, K2 may be identical. In particular, the identity may be given if the first battery cell 102 and the second battery cell 104 are identical. In this case, it may also be assumed that the inductances L1, L2 are identical. Considering these assumptions, as well as the previously stated equation, the following may apply to the voltage induced in the third sensing line 114:

$$v_{ind} = jwi_1K_1\sqrt{L_1L_3} - jwi_1K_1\sqrt{L_1L_3}$$

Considering the foregoing explanations, in an example, it may be found that the first induced voltage and the second induced voltage at least approximately cancel out each other. Therefore, as an effect, it can be assumed that the resulting induced voltage in the third sensing line 114 is zero or at least approximately zero.

$$v_{ind} = 0$$

Based on the knowledge that the voltage induced in the third sensing line 114 is at least approximately zero, there is no longer a need for costly and potentially inaccurate measurement of the impedances of the first battery cell 102, the second battery cells 104, and/or the third sensing line. In fact, the battery system 100, as shown schematically in Figure 4 for example, allows for no subsequent correction of the voltages sensed by the measurement unit 106 via the first, second, and third sensing lines 110, 112, 114 to be necessary since the sensed voltages are not adversely affected by magnetic fields, at least based on the aforementioned assumptions.

The first, second, and third sensing lines 110, 112, 114 are coupled to the measurement unit 106. In an example, the measurement unit 106 may be configured to sense a voltage, referred to as the first measurement voltage, that is dropped between the first sensing line 110 and the third sensing line 114. In an example, the measurement unit 106 may be configured to sense a voltage, referred to as the second measurement voltage, that drops between the third sensing line 114 and the second sensing line 112. The battery system 100 may comprise a control unit 156. The measurement unit 106 may form part of the control unit 156. The control unit 156 may be configured to determine, based on the first measurement voltage and/or the second measurement voltage, an impedance of the first battery cell 102 and/or an impedance of the second battery cell 104. In an example, the control unit 156 may be configured to determine, based on the impedance of the first battery cell 102 and/or the impedance of the second battery cell 104, a condition, referred to as a health condition, of the first battery cell 102 and/or the second battery cell 104.

The battery system 100 has the advantage that the first measurement voltage and/or the second measurement voltage can be measured robustly with respect to electromagnetic couplings within the battery system 100. Possible small errors of the first and or second measurement voltage due to the electromagnetic couplings can be neglected in an example. Therefore, the battery system 100 offers the advantage that an error-robust determination of the electrical impedance of the first and/or second battery cells 102, 104 is possible via the first and/or second measurement voltage. The at least one, electrical impedance can be used to accurately determine the actual state of health of the respective battery cell 102, 104.

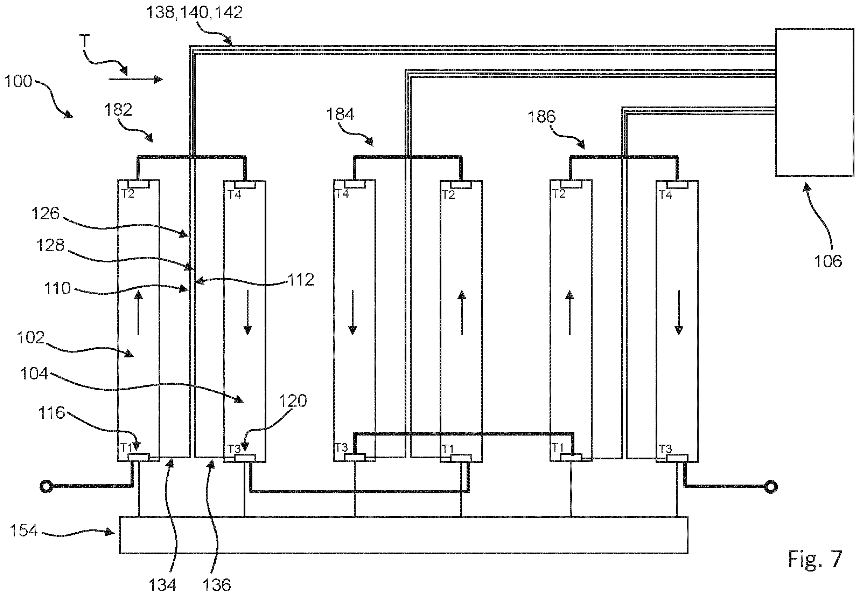

The battery system 100 comprises the first sensing line 110, the second sensing line 112 and the third sensing line 114. At least one sensing line 110, 112, 114 of these three sensing lines 110, 112, 114 comprises a central portion 124 which is arranged centrally between the first battery cell 102 and the second battery cell 104 and which extends in particular parallel to the two battery cells 102, 104 in longitudinal direction L in the first intermediate space 132. Figure 4 schematically illustrates an example of the battery system 100, wherein in this example of the battery system 100 only the third sensing line 114 comprises a central portion 124 extending along the entire length of the first intermediate space 132 (in the longitudinal direction L). In this example of the battery system 100, the first and second sensing lines 110, 112 do not comprise a central section. It should be noted that in Figure 4, an example of a possible embodiment of the battery system 100 is schematically illustrated. In principle, the battery system 100 can also have a different configuration, so that, for example, the first sensing line 110 and/or the second sensing line 112 each also comprise a central section 126, 128. Such an example will be discussed in connection with Figure 7. First, however, the example of the battery system 100 will continue to be discussed, for example as shown schematically in Figure 4.

As previously mentioned, for the battery system 100, it may be provided that the third sensing line 114 comprises a central section 124, which may also be referred to as a third central section 126. Further, it may be provided for the battery system 100 that the first sensing line 110 and the second sensing line 112 each comprise no central section. In the example shown in Figure 4, the battery system 100 is configured such that the first sensing line 110 extends from the first battery terminal 116 directly to the measurement unit 106 and that the second sensing line 112 extends from the third battery terminal 120 directly to the measurement unit 106. In an example, the first sensing line 110 and the second sensing line 112 are each disposed outside of the first intermediate space 132. The example of the battery system 100 of Figure 4 provides the advantage that a length of the first sensing line 110 and a length of the second sensing line 112 may be very short, such that a potential error due to a voltage induced in the first sensing line 110 and/or the second sensing line 112 is negligible. Alternatively or additionally, it may be provided that the first sensing line 110 and the second sensing line 112 are disposed at least substantially centrally between the first driving line 150 and the second driving line 152. As an effect, it may be assumed, in a manner analogous to the preceding discussion, that possible induced voltages in the first and second sensing lines 110, 112 cancel out.

In an example, the first battery cell 102, the second battery cell 104, the interconnect line 108, and the at least one central section 124 may form a so-called battery block 144 of the battery system 100. In addition, the first sensing line 110, the second sensing line 112, and the third sensing line 114 may each form a part of the battery block 144.

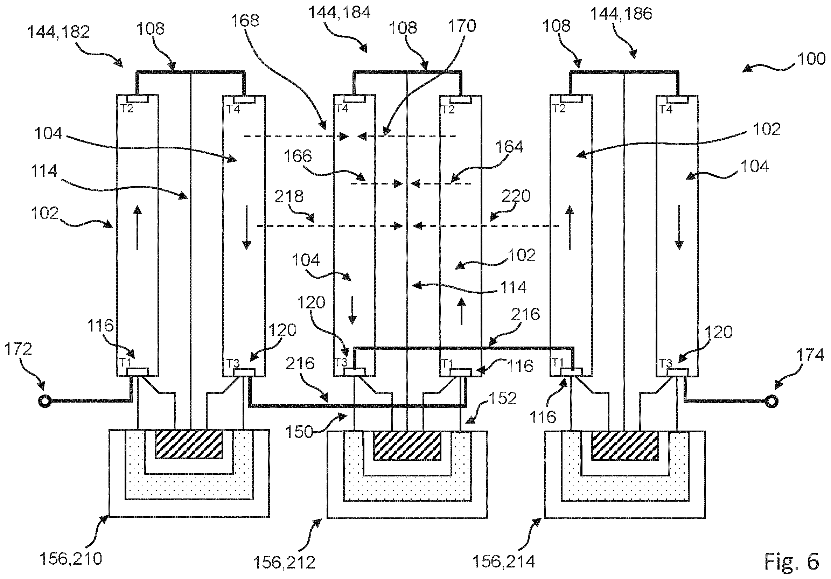

In the example of the battery system 100 shown in Figure 4, the battery block 144 is coupled to the control unit 156. Figure 6 schematically illustrates another example of a battery system 100. The battery system 100 comprises a plurality of battery blocks 144. In an example, the battery system 100 may comprise a first battery block 182, a second battery block 184, and a third battery block 186. Each battery block 144, 182, 184, 186 may be coupled to a respective associated control unit 156. For example, the first battery block 182 may be coupled to a first control unit 210. The second battery block 184 may be coupled to a second control unit 212. The third battery block 186 may be coupled to a third control unit 114. In an example, the battery blocks 144, 182, 184, 186 may be configured identically. The control units 156, 210, 212, 214 may also be identically configured. For each battery block 182, 184, 186 and for each control unit 210, 212, 214, reference is made to the advantageous explanations, preferred features, technical effects and advantages in an analogous manner as previously explained for the battery block 144 and the control unit 156, respectively.

If the battery system 100 comprises a plurality of battery blocks 144, such as in the battery system 100 of Figure 6, then the plurality of battery blocks 144 may be arranged in parallel side-by-side. In an example, the battery system 100 comprises at least two battery blocks 144, at least three battery blocks 144, or at least four battery blocks 144. In each second battery block 144, an arrangement of the first and second battery cells 102, 104 may be interchanged. In the example of the battery system 100 of Figure 6, the arrangement of the first and second battery cells 102, 104 of the second battery block 184 is reversed from the arrangement of the first and second battery cells 102, 104 of the first battery block 182. Two adjacent battery blocks 144, such as the first battery block 182 and the second battery block 184, may be interconnected by a second interconnection line 216 such that the second interconnection line 216 extends from the third battery terminal 120 of one battery block 182 to the first battery terminal 116 of the other battery block 184. Thus, the second interconnection line 216 may electrically connect the third battery terminal 120 of the first battery block 182 to the first battery terminal 116 of the second battery block 184. Another, second interconnection line 216 may electrically connect the third battery terminal 120 of the second battery block 184 to the first battery terminal 116 of the third battery block 186. As a result, the plurality of battery blocks 144, 182, 184, 186 may be electrically coupled in series. The first battery terminal 116 of the first battery block 182 may be electrically coupled to a first system terminal 172. The second battery terminal 120 of the last battery block 186 may be electrically coupled to a second system terminal 174. Between the first system terminal 172 and the second system terminal 174, the plurality of battery cells 102, 104 may be electrically connected in series.

Each battery block 182, 184, 186 of the battery system 100, as schematically illustrated in Figure 6, for example, may be configured analogously to the battery block 144 of the battery system 100, as schematically illustrated in Figure 4, for example. Each control unit 210, 212, 214 of the battery system 100, as schematically illustrated in Figure 6, for example, may be configured analogously to the control unit 156, as schematically illustrated in Figure 4, for example.

For the following explanations, reference is made in an example to the second battery block 184 and in particular the second control unit 212. However, the following explanations may apply in an analogous manner to the further battery blocks 182, 186 and the further control units 210, 214, respectively.

If a driving current is generated through the series connection of the first driving line 150, the first battery cell 102, the first connecting line 108, the second battery cell 104, and the second driving line 152 via the driving unit 156 of the second control unit 212, a first magnetic coupling 164 is created between the first battery cell 102 of the second battery block 184 and the central portion 124 of the third sensing line 114 of the second battery block 184. Also, a second magnetic coupling 166 is created between the second battery cell 104 of the second battery block 184 and the central section 124 of the third sensing line 114 of the second battery block 184. The voltages created in the central section 124 of the third sensing line 114 of the second battery block 184 due to the two magnetic couplings 164, 166 cancel each other out.

In an example, it is to be assumed that the battery blocks 144, 182, 184, 186 are configured identically. Also, in an example, it may be assumed that the control units 156, 210, 212, 214 are identically configured. Further, based on the previously mentioned assumptions, in an example, it may be assumed that the two magnetic couplings 168, 170 also induce mutually cancelling, electrical voltages. Further, based on the aforementioned assumptions, it may further be assumed that the two magnetic couplings 218, 220 also induce mutually cancelling, electrical voltages. Other corresponding pairs of magnetic couplings can be determined by those skilled in the art from the schematic representation of the battery system 100 as shown in an example in Figure 6 without further difficulty, as the principle has been previously explained. As a result, it can be seen that the voltages that can be sensed by the measurement units 106 are at least substantially not negatively affected by magnetic couplings. As a result, the measurement units 106 are able to detect electrical voltages that allow error-free and reliable determination of the impedances of the battery cells 102, 104.

Figure 7 schematically illustrates another example of a battery system 100. For the battery system 100, reference is made to the advantageous explanations, preferred features, technical effects, and benefits in an analogous manner as already explained for the battery system 100.

The battery system 100 comprises a plurality of battery blocks 182, 184, 186. Unlike the preceding discussion of battery blocks 144, 182, 184, 186, each battery block 182, 184, 186 of battery system 100, as shown for example in Figure 7, comprises two central sections 126, 128, referred to as first central section 126 and second central section 128. Each central section 126, 128 of a battery block 182, 184, 186 is centrally located between the first and second battery cells 102, 104 of the respective battery block 182, 184, 186 and extends in a longitudinal direction L of the respective battery block 182, 184, 186. For each central section 126, 128, reference is therefore made to the preceding explanations, preferred features, technical effects and advantages in an analogous manner as already explained for the central section 124. The first and second central sections 126, 128 may be arranged in parallel.

In the following, reference is made in an example to the first battery block 182. The following explanations may apply in an analogous manner to the second battery block 184 and to the third battery block 186.

The first central section 126 may be connected to the first battery terminal 116 of the first battery cell 102 via a (further) section 134 of the first sensing line 110. The section 134 may also be referred to as the first connection section 134. The second central section 128 may be connected to the third battery terminal 120 of the second battery cell 104 via a (further) section 136 of the second sensing line 112. The section 136 may also be referred to as the second connection section 136. The first connection section 134 and the second connection section 136 may each extend at least substantially in the transverse direction T. As a result, voltage induction into the first and second connection sections 134, 136 may be prevented or reduced to a very small value.

In an example, the first central section 126 may be coupled to the measurement unit 106 via a (further) section 138 of the first sensing line 110. The further section 138 may also be referred to as the first connection section 138. The second central section 128 may be coupled to the measurement unit 106 via a (further) section 140 of the second sensing line 112. The further section 140 may also be referred to as the second connection section 140. The third sensing line 114 may be partially or fully formed by a (further) section 142. The section 142 of the third sensing line 114 may also be referred to as the third connection section 142. Each connection section 138, 140, 142 may be disposed fully or mostly outside of the first intermediate space 132 extending between the first battery cell 102 and the second battery cell 104. As a result, voltage induction into the connection sections 138, 140, 142 may be prevented or reduced to a very small value.

As previously mentioned, the preceding two paragraphs may apply in an analogous manner to each of the second battery block 184 and the third battery block 186.

In the example of the battery system 100 of Figure 7, a common measurement unit 106 is provided for the battery blocks 182, 184, 186. This measurement unit 106 may perform the function of the multiple measurement units 106 of Figure 6 and/or be configured accordingly. The battery system 100 may further comprise a common driver unit 154. The driver unit 154 may perform the function of the plurality of driver units 154 of Figure 6 and/or be configured accordingly.

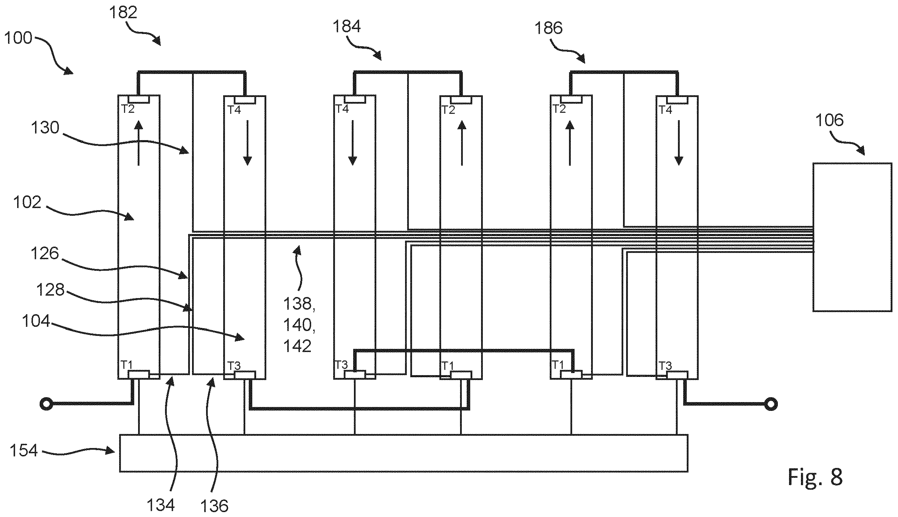

Figure 8 schematically illustrates another example of a battery system 100. For the battery system 100 of Figure 8, reference is preferably made to the advantageous explanations, preferred features, technical effects and advantages in an analogous manner as they have been explained for the battery system 100 of Figure 7.

The battery system 100 of Figure 8 differs from the battery system 100 of Figure 7 in that, for example, the third sensing line 114 comprises a (further) central portion 130. In addition, it is possible that the central sections 126, 128, 130 each extend over only a partial length of the total length of the intermediate space 132. Furthermore, the connecting sections 138, 140, 142 may extend across the battery blocks 182, 184, 186 in the transverse direction T. Because of their orientation in the transverse direction T, voltage induction into the interconnecting sections 138, 140, 142 may be prevented or reduced to a very small value.

For the battery systems of Figures 6, 7 and 8, the advantages apply in an analogous manner as explained in connection with the battery system 100 of Figure 4.

Although the described exemplary embodiments disclosed herein focus on systems, devices and units, the present disclosure is not necessarily limited to the example embodiments illustrate herein.

The systems, devices and units described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

**Claims**

1. A battery system comprising:

   a first battery cell, a second battery cell, a measurement unit, a first interconnection line, a first sensing line, a second sensing line, and a third sensing line,
   wherein the first battery cell extends in a longitudinal direction from a first battery terminal to a second battery terminal,
   wherein the second battery cell extends in the longitudinal direction from a third battery terminal to a fourth battery terminal,
   wherein the second battery terminal is coupled to the fourth battery terminal via the first interconnection line,
   the first sensing line being coupled between the first battery terminal and the measurement unit,
   the second sensing line being coupled between the third battery terminal and the measurement unit,
   wherein the third sensing line is coupled between the first interconnection line and the measurement unit,
   wherein the first to third sensing lines comprise at least one section referred to as a central section, and
   wherein each central section is arranged centrally between the first and second battery cells and extends in the longitudinal direction.

2. The battery system according to the preceding claim, wherein the third sensing line forms one central section referred to as the third central section, and wherein the first and second sensing lines each comprise no central section.

3. The battery system according to the preceding claim, wherein each of the first and second sensing lines is arranged outside a space referred to as a first intermediate space between the first and second battery cells.

4. The battery system according to claim 1, wherein the first sensing line forms one central section referred to as the first central section, wherein the second sensing line forms another central section referred to as the second central section, wherein the third sensing line forms another central section referred to as the third central section.

5. The battery system according to any of the preceding claims, wherein the first central section is coupled to the first battery terminal via a section of the first sensing line referred to as the first terminal section, and wherein the second central section is coupled to the third battery terminal via a section of the second sensing line referred to as the second terminal section.

6. The battery system according to claim 5, wherein the first and second terminal sections each extend in a direction referred to as the transverse direction, which is transverse to the longitudinal direction.

7. The battery system according to any of the preceding claims 5 to 6, wherein the first central section is coupled to the measurement unit via another section of the first measuring line referred to as the first connecting section, wherein the second central section is coupled to the measurement unit via another section of the second measuring line referred to as the second connecting section, and wherein the third central section is coupled to the measurement unit via another section of the third measuring line referred to as the third connecting section.

8. The battery system according to the preceding claim, wherein the first to third connecting sections are arranged mostly outside a space referred to as a first intermediate space between the first and second battery cells.

9. The battery system according to any of the preceding claims 7 to 8, wherein the first to third connecting sections are arranged in parallel.

10. The battery system according to any of the preceding claims, wherein the measurement unit is configured to detect an electrical impedance of the first and second battery cells.

11. The battery system according to any of the preceding claims, wherein the first battery cell, the second battery cell, the first interconnection line, the first sensing line, the second sensing line, and the third sensing line form a battery block of the battery system, and wherein the battery system comprises a plurality of battery blocks.

12. The battery system according to any of the preceding claims, wherein the battery blocks are arranged parallel to each other.

13. The battery system according to any of the preceding claims 11 to 12, wherein every second battery block has the arrangement of the first and second battery cells interchanged.

14. The battery system according to any of the preceding claims 11 to 13, wherein each two battery bocks arranged side by side are connected to each other via a second interconnection line such that the second interconnection line extends from the third terminal one of the two battery bocks to the first terminal the other of the two battery bocks.

15. The battery system according to any of the preceding claims, wherein the battery cells are arranged in parallel with each other.

Fig. 1

Fig. 3

Fig. 2

Fig. 5

Fig. 4

Fig. 6

EP 4 531 166 A1

Fig. 7

Fig. 8

Europäisches
Patentamt

European
Patent Office

Office européen
des brevets

# EUROPEAN SEARCH REPORT

**Application Number**

EP 23 20 0167

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/204679 A1 (BARSUKOV YEVGEN PAVLOVICH [US] ET AL) 29 June 2023 (2023-06-29) * paragraph [0253] - paragraph [0261]; figures 1, 28a-b, 32 * | 1-15 | INV. H01M10/48 G01R31/389 G01R31/396 H01M50/51 H01M50/569 H01M50/548 |
| X | WO 2012/090948 A1 (SHARP KK [JP]; WATANABE YUKI ET AL.) 5 July 2012 (2012-07-05) * abstract; figure 10A * | 1-9,15 | |
| X | US 2015/037657 A1 (HU SUNHYE [KR]) 5 February 2015 (2015-02-05) * paragraphs [0031], [0041] - paragraph [0043]; figures 1a,1b * | 1-9,15 | |
| X | US 2017/179542 A1 (CHO YONG JUN [KR] ET AL) 22 June 2017 (2017-06-22) * paragraph [0051] - paragraph [0055]; figures 2-5 * | 1-9, 11-15 | |
| X | US 2014/134462 A1 (CHOI JUN SEOK [KR] ET AL) 15 May 2014 (2014-05-15) * paragraph [0069] - paragraph [0082]; figures 4-6 * | 1-6,15 | TECHNICAL FIELDS SEARCHED (IPC) H01M G01R H02J |
| X | WO 2019/164974 A1 (NIO USA INC [US]) 29 August 2019 (2019-08-29) * paragraph [0073] - paragraph [0078]; figures 1-3 * | 1-9, 11-15 | |
| A | US 10 386 422 B2 (LITHIUM BALANCE AS [DK]) 20 August 2019 (2019-08-20) | 1-15 | |

The present search report has been drawn up for all claims

| Place of search | Date of completion of the search | Examiner |
|---|---|---|
| Munich | 23 February 2024 | Topalov, Angel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 20 0167

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2024

| Patent document cited in search report | | | Publication date | Patent family member(s) | | | Publication date |
|---|---|---|---|---|---|---|---|
| US 2023204679 | A1 | | 29-06-2023 | CN | 114720895 | A | 08-07-2022 |
| | | | | US | 2022163592 | A1 | 26-05-2022 |
| | | | | US | 2023204679 | A1 | 29-06-2023 |
| WO 2012090948 | A1 | | 05-07-2012 | JP | 5709517 | B2 | 30-04-2015 |
| | | | | JP | 2012142095 | A | 26-07-2012 |
| | | | | WO | 2012090948 | A1 | 05-07-2012 |
| US 2015037657 | A1 | | 05-02-2015 | EP | 2833432 | A2 | 04-02-2015 |
| | | | | KR | 20150015342 | A | 10-02-2015 |
| | | | | US | 2015037657 | A1 | 05-02-2015 |
| US 2017179542 | A1 | | 22-06-2017 | CN | 107996006 | A | 04-05-2018 |
| | | | | EP | 3300135 | A1 | 28-03-2018 |
| | | | | JP | 6594455 | B2 | 23-10-2019 |
| | | | | JP | 2018521469 | A | 02-08-2018 |
| | | | | KR | 20170010974 | A | 02-02-2017 |
| | | | | US | 2017179542 | A1 | 22-06-2017 |
| | | | | WO | 2017014448 | A1 | 26-01-2017 |
| US 2014134462 | A1 | | 15-05-2014 | CN | 103703606 | A | 02-04-2014 |
| | | | | EP | 2725650 | A2 | 30-04-2014 |
| | | | | JP | 5898314 | B2 | 06-04-2016 |
| | | | | JP | 6131499 | B2 | 24-05-2017 |
| | | | | JP | 2014527688 | A | 16-10-2014 |
| | | | | JP | 2016048693 | A | 07-04-2016 |
| | | | | KR | 20130018494 | A | 25-02-2013 |
| | | | | US | 2014134462 | A1 | 15-05-2014 |
| | | | | WO | 2013019008 | A2 | 07-02-2013 |
| WO 2019164974 | A1 | | 29-08-2019 | NONE | | | |
| US 10386422 | B2 | | 20-08-2019 | CN | 107076801 | A | 18-08-2017 |
| | | | | EP | 3186651 | A1 | 05-07-2017 |
| | | | | US | 2017219660 | A1 | 03-08-2017 |
| | | | | WO | 2016012922 | A1 | 28-01-2016 |

EPO FORM P0459

For more details about this annex : see Official Journal of the European Patent Office, No. 12/82

EP 4 531 166 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200036058 A1